(19) Europäisches Patentamt
European Patent Office
Office européen des brevets

(11) **EP 2 341 614 B1**

(12) **FASCICULE DE BREVET EUROPEEN**

(45) Date de publication et mention
de la délivrance du brevet:
**22.01.2014 Bulletin 2014/04**

(51) Int Cl.:
***H03F 1/32*** *(2006.01)*

(21) Numéro de dépôt: **10196619.0**

(22) Date de dépôt: **22.12.2010**

(54) **Dispositif de linéarisation pour amplificateur de puissance**

Linearisierungsvorrichtung für Leistungsverstärker

Linearization device for a power amplifier

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.12.2009 FR 0906280**

(43) Date de publication de la demande:
**06.07.2011 Bulletin 2011/27**

(73) Titulaires:
• **Thales**
**92200 Neuilly Sur Seine (FR)**
• **Université de Nantes**
**44035 Nantes Cedex 1 (FR)**

(72) Inventeurs:
• **Peyresoubes, Georges**
**92700 Colombes (FR)**
• **Feuvrie, Bruno**
**44035 Nantes (FR)**
• **Abi Hussein, Mazen**
**44035 Nantes (FR)**
• **Wang, Yide**
**44035 Nantes (FR)**

(74) Mandataire: **Collet, Alain**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A1- 1 482 637       WO-A1-2004/086607
WO-A2-2008/078195    US-A- 6 141 390
US-A1- 2003 063 686   US-A1- 2005 253 745**

• **SUNGCHUL HONG ET AL: "Weighted Polynomial
Digital Predistortion for Low Memory Effect
Doherty Power Amplifier", IEEE TRANSACTIONS
ON MICROWAVE THEORY AND TECHNIQUES,
IEEE SERVICE CENTER, PISCATAWAY, NJ, US
LNKD- DOI:10.1109/TMTT.2007.895167, vol. 55,
no. 5, 1 mai 2007 (2007-05-01), pages 925-931,
XP011180977, ISSN: 0018-9480**
• **MAO-CHING CHIU ET AL: "Predistorter Based on
Frequency Domain Estimation for Compensation
of Nonlinear Distortion in OFDM Systems", IEEE
TRANSACTIONS ON VEHICULAR
TECHNOLOGY, IEEE SERVICE CENTER,
PISCATAWAY, NJ, US, vol. 57, no. 2, 1 mars 2008
(2008-03-01), pages 882-892, XP011201939, ISSN:
0018-9545**

**EP 2 341 614 B1**

**Description**

La présente invention concerne un dispositif de linéarisation pour amplificateur de puissance. Elle s'applique notamment au domaine des amplificateurs de puissance utilisés dans des chaînes d'émission de systèmes de radiocommunication.

Dans le domaine des radiocommunications, l'émission de signaux requiert l'utilisation d'amplificateurs de puissance, indispensables dans des chaînes d'émission. Les amplificateurs de puissance utilisés en radiocommunications sont d'une manière générale non-linéaires ; les phénomènes de non-linéarité sont d'autant plus présents que les amplificateurs de puissance actuels fonctionnent dans des zones proches de leur saturation, dans un souci d'optimisation de leur rendement, que la dynamique d'entrée est importante, et que des signaux à enveloppe variable sont de plus en plus utilisés. Le comportement non-linéaire des amplificateurs de puissance génère notamment sur les signaux émis des distorsions de phase et d'amplitude, lesquelles génèrent notamment des remontées spectrales en dehors du canal du signal utile. De telles remontées spectrales sont indésirables : d'une part les exigences appliquées aux dispositifs de radiocommunication, en termes d'efficacité spectrale, sont de plus en plus sévères, la diversité de dispositifs communicant sans fil étant de plus en plus grande. Des normes définissent des exigences précises dans ce sens. D'autre part, les remontées spectrales ont une influence négative sur le bon fonctionnement de dispositifs situés en proximité du système comprenant un amplificateur de puissance. En effet, un véhicule par exemple, peut être équipé d'un grand nombre de systèmes fonctionnant dans des gammes de fréquences relativement proches. Les distorsions peuvent par exemple être caractérisées par le rapport entre la puissance du signal dans le canal utile et la puissance du signal générée par les distorsions dans les canaux adjacents, ce rapport étant communément désigné sous le sigle d'ACPR, correspondant à la terminologie anglaise "Adjacent Channel Power Ratio" ; d'autres valeurs caractéristiques peuvent également être utilisées, telles que la magnitude du vecteur d'erreur, communément désignée sous le sigle EVM selon la terminologie anglaise "Error Vector Magnitude".

La linéarisation des amplificateurs de puissance est une solution privilégiée pour réduire les phénomènes de distorsions non-linéaires dans les chaînes de transmission des émetteurs et augmenter leur rendement. Il existe différentes techniques de linéarisation des amplificateurs de puissance connues de l'état de la technique. Parmi les diverses techniques connues de linéarisation, la prédistorsion numérique adaptative en bande de base est l'une des plus efficaces en termes de rentabilité, grâce à la mise en oeuvre numérique, offrant précision et flexibilité. Cette technique permet d'obtenir de très bonnes performances de linéarité, qui peuvent être atteintes avec de meilleurs rendements en puissance, ainsi qu'une complexité et un coût réduits par rapport aux techniques analogiques existantes. D'une manière générale, les techniques de prédistorsion consistent à transformer les signaux en amont de l'amplificateur de puissance, afin que la combinaison avec l'amplificateur de puissance rende le système global linéaire. Ainsi, si un circuit effectue cette transformation, une linéarisation parfaite est en théorie réalisable, en plaçant celui-ci en amont de l'amplificateur de puissance. Un tel circuit est qualifié de "pré-inverse" et est appelé couramment "précompensateur" ou encore "prédistordeur".

Un exemple peut être trouvé dans le document de brevet WO 2004/086607.

Il existe divers techniques de réalisations de prédistorsion numérique adaptative en bande de base. Chacune d'entre elle consiste à transposer en bande de base le signal de transmission radiofréquence en sortie de l'amplificateur de puissance, et de numériser ses composantes en phase et en quadrature par un convertisseur analogique — numérique. Les échantillons en bande de base sont alors traités dans un processeur numérique spécialisé, avec un algorithme d'identification qui les compare avec les échantillons correspondant au signal d'entrée de référence. Le processus d'identification des paramètres du précompensanteur est exécuté en numérique, et cherche à minimiser l'erreur entre l'entrée et la sortie de l'amplificateur de puissance. Après un temps de convergence caractéristique de l'algorithme d'identification, le précompensateur peut opérer comme le pré-inverse exact du modèle équivalent en bande de base de l'amplificateur de puissance. L'algorithme peut par exemple être mis en oeuvre dans un circuit intégré spécifique de type "ASIC" selon l'acronyme correspondant à la  terminologie anglaise "Application-Specific Integrated Circuit", ou bien dans un circuit programmable de type "FPGA" selon le sigle correspondant à la terminologie anglaise "Field Programmable Gate Array), ou encore dans un processeur de traitement numérique, communément désigné par le sigle "DSP" selon la terminologie anglaise "Digital Signal Processor".

Plus particulièrement, parmi les techniques connues de prédistorsion numérique adaptative en bande de base, il est possible d'en citer deux catégories, s'appuyant sur deux approches de mise en oeuvre du précompensateur :

- la mise en oeuvre par des tables de correspondance ou "TC", stockées dans des mémoires communément désignées "LUT" suivant l'acronyme correspondant à la terminologie anglaise "Look-Up Table". Cette catégorie est particulièrement adaptée aux amplificateurs dont les effets mémoire sont négligeables,
- la mise en oeuvre par des modèles paramétriques. La gamme des modèles paramétriques dans ce type d'application est vaste : les modèles paramétriques peuvent être des modèles polynomiaux simples sans mémoire, jusqu'à des modèles nettement plus complexes, tels que des modèles à séries de Volterra et des modèles à réseaux de neurones.

Le précompensateur est par exemple un processeur numérique qui traite l'enveloppe complexe du signal d'entrée, représentée généralement par ses composantes en phase et en quadrature désignées respectivement par les lettres I et Q, et échantillonnées à une fréquence déterminée ; ainsi, l'échantillon se présentant en entrée du précompensateur à un instant donné est à valeur complexe. Afin de corriger simultanément les distorsions d'amplitude et de phase de l'amplificateur de puissance, l'amplitude et la phase, ou les parties réelle et imaginaire de chaque valeur complexe correspondant à un échantillon en entrée, sont ajustées.

La technique des tables de correspondance offre l'avantage d'être simple à mettre en oeuvre ; cependant cette technique présente l'inconvénient du temps de convergence relativement long. En outre, l'usage de tables de dimensions importantes peut être requis, nécessitant des mémoires de stockage pouvant être difficiles à mettre en oeuvre.

La mise en oeuvre de modèles paramétriques augmente considérablement la complexité du système, et peut engendrer des problèmes d'instabilité lorsque les ordres des polynômes employés sont élevés, voire des problèmes de non-convergence des algorithmes.

Un but de la présente invention est de pallier au moins les inconvénients précités, en proposant un dispositif de linéarisation d'un amplificateur de puissance basé sur la technique de prédistorsion numérique adaptative en bande de base, mettant en oeuvre des calculs offrant des temps de convergence courts, et ne présentant pas de problèmes d'instabilité, même lorsque des modèles mathématiques complexes sont utilisés.

Un autre avantage de la présente invention est qu'elle ne requiert pas l'usage de mémoires de grande capacité.

A cet effet, l'invention a pour objet un dispositif de linéarisation pour amplificateur de puissance par prédistorsion numérique adaptative en bande de base comprenant un bloc pré-inverse recevant un signal d'entrée discrétisé complexe $\tilde{x}_e(n)$ et restituant en entrée de l'amplificateur de puissance un signal prédistordu complexe $\tilde{x}_p(n)$, caractérisé en ce que le bloc pré-inverse comprend un premier module et un second module recevant en entrée le module du signal d'entrée complexe $|\tilde{x}_e(n)|$ dont la valeur est comprise dans un domaine d'amplitudes variant entre deux valeurs minimale et maximale, le domaine d'amplitude étant découpé en une pluralité de segments, le premier module comprenant une table de correspondance associant à chaque valeur du module du signal d'entrée complexe contenue dans un segment donné, un jeu prédéfini d'une pluralité de paramètres définissant un modèle paramétrique mis en oeuvre dans le second module via une fonction Fj, le second module restituant une valeur $F_j(|\tilde{x}_e(n)|)$, le signal prédistordu complexe résultant de la multiplication du signal d'entrée complexe $\tilde{x}_e(n)$ par la valeur $F_j(|\tilde{x}_e(n)|)$.

Dans un mode de réalisation de l'invention, le dispositif de linéarisation pour amplificateur de puissance peut être caractérisé en ce que chacun desdits jeux de paramètres prédéfinis pour un segment k donné définit les coefficients complexes d'un polynôme d'ordre $P_k$.

Dans un mode de réalisation de l'invention, le dispositif de linéarisation pour amplificateur de puissance peut être caractérisé en ce que, l'amplitude minimale $A_{min}$ étant nulle, le domaine d'amplitude est découpé en un nombre $N_{TCP}$ segments de même longueur $L_{seg}$ égale au rapport de l'amplitude maximale $A_{max}$ du domaine d'amplitude au nombre de segments $A_{max}/N_{TCP}$, les segments du domaine d'amplitude étant alors des intervalles $[(j-1)L_{seg}, jL_{seg}]$, la table de correspondance associant pour chacun des intervalles un jeu de paramètres complexes $\alpha_{j1},....,\alpha_{jP_j}$ correspondant aux coefficients d'ordre $j_1, ... jP_j$ du polynôme d'ordre $P_j$.

Dans un mode de réalisation de l'invention, le dispositif de linéarisation pour amplificateur de puissance peut être caractérisé en ce que l'identification du bloc pré-inverse est basée sur une architecture indirecte formée par un bloc d'identification disposé en parallèle de l'amplificateur de puissance, le bloc d'identification identifiant les jeux de paramètres pour chaque segment du domaine d'amplitude du module du signal d'entrée complexe $|\tilde{x}_e(n)|$ en minimisant l'erreur entre le signal d'entrée $\tilde{x}_p(n)$ et le signal de sortie $\tilde{y}(n)$ de l'amplificateur de puissance en au moins une itération.

Dans un mode de réalisation de l'invention, le dispositif de linéarisation pour amplificateur de puissance peut être caractérisé en ce que le bloc d'identification comprend un atténuateur atténuant le signal de sortie $\tilde{y}(n)$ de l'amplificateur de puissance par un gain $1/g_d$ égal à l'inverse du gain désiré de l'amplificateur de puissance, le signal complexe atténué $\tilde{z}(n)$ étant appliqué en entrée d'un bloc post-inverse restituant en sortie un signal $\tilde{z}_p(n)$, un bloc d'estimation déterminant les paramètres d'identification du bloc pré-inverse à partir de la différence entre le signal d'entrée $\tilde{x}_p(n)$ de l'amplificateur de puissance et le signal de sortie $\tilde{z}_p(n)$ du bloc post-inverse par une minimisation de l'erreur quadratique par la technique des moindres carrés.

D'autres caractéristiques et avantages de l'invention apparaîtront à la lecture de la description, donnée à titre d'exemple, faite en regard des dessins annexés qui représentent :

- la figure 1, le schéma de principe d'une chaîne d'émission comprenant un amplificateur de puissance associé à un dispositif connu de prédistorsion numérique adaptative en bande de base ;
- la figure 2, le schéma de principe du bloc d'amplification d'une chaîne d'émission comprenant un amplificateur de puissance associé à un dispositif de linéarisation selon un mode de réalisation de la présente invention ;
- les figures 3a et 3b, des courbes représentant les caractéristiques AM/AM et AM/PM, respectivement, de l'amplificateur de puissance, du précompensateur et du système global.

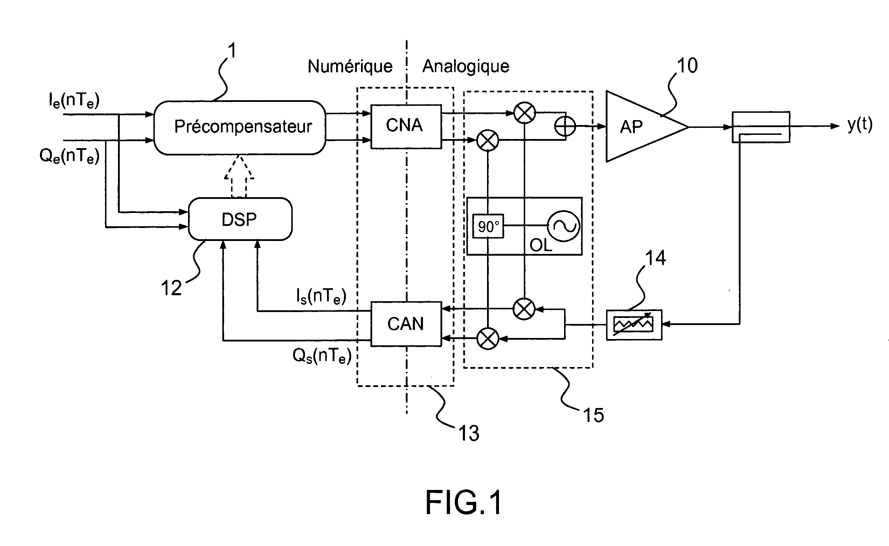

La figure 1 présente le schéma de principe d'une chaîne d'émission comprenant un amplificateur de puissance associé à un dispositif connu de prédistorsion numérique adaptative en bande de base.

Une chaîne d'émission en elle-même connue de l'état de la technique, destinée à émettre un signal radiofréquence par exemple modulé en phase et en amplitude, peut comprendre un amplificateur de puissance 10 restituant un signal amplifié y(t). Le signal d'entrée numérisé peut être en bande de base, par exemple après une mise en forme par un filtrage passe-bas réalisé par un filtre de transmission non représenté sur la figure, puis décomposé en composantes en phase et en quadrature $I_e(nT_e)$ et $Q_e(nT_e)$, Te étant l'inverse de la fréquence d'échantillonnage des signaux. Les composantes $I_e(nT_e)$ et $Q_e(nT_e)$ sont appliquées en entrée d'un précompensateur 11, restituant après traitement des deux signaux d'entrées, deux signaux numériques de sortie.

En parallèle, les composantes I et Q sont appliquées en entrée d'un module numérique de traitement du signal DSP 12.

Un bloc de conversion 13 comprend un convertisseur numérique - analogique CNA et un convertisseur analogique-numérique CAN. Les signaux numériques de sortie du précompensateur 11 sont convertis en signaux analogiques par le CNA du bloc de conversion 13. Un bloc de modulation / démodulation I/Q 15 comprend un modulateur I/Q et un démodulateur I/Q. Les signaux de sortie du précompensateur 11, après conversion en signaux analogiques, sont modulés par le modulateur I/Q du bloc de modulation / démodulation I/Q 15 ; le signal en résultant attaque l'entrée de l'amplificateur de puissance 10. Le signal y(t) de sortie de l'amplificateur de puissance 10 est prélevé et appliqué en entrée du DSP 12, après démodulation par le démodulateur I/Q du bloc de modulation / démodulation I/Q 15, et conversion des signaux I et Q en signaux $I_S(nT_e)$ et $Q_S(nT_e)$ numériques par le CAN du bloc de conversion 13.

Les composantes en phase et en quadrature $I_s(nT_e)$ et $Q_s(nT_e)$ en bande de base sont ainsi traitées dans le DSP 12 avec un algorithme d'identification les comparant avec les échantillons correspondants des composantes en phase et en quadrature du signal d'entrée de référence $I_e(nT_e)$ et $Q_e(nT_e)$. Après convergence de l'algorithme d'identification, des paramètres de configuration correspondant à l'inverse des caractéristiques AM/AM et AM/PM sont communiqués au précompensateur 11, afin que celui-ci opère comme le pré-inverse du modèle équivalent en bande de base de l'amplificateur de puissance 10.

Une première technique connue de mise en oeuvre de prédistorsion numérique adaptative en bande de base, est la technique des tables de correspondance ou LUT. Cette technique est la plus utilisée, et présente notamment l'avantage d'être relativement simple à mettre en place, tout en étant particulièrement adaptée aux amplificateurs de puissance dont les effets mémoire sont négligeables, comme par exemple dans des applications telles que des systèmes de communication sans fil à bande étroite. Il existe diverses méthodes de mise en oeuvre de tables de correspondance.

Une première méthode connue de mise en oeuvre est la méthode dite du précompensateur par correspondance, communément désignée selon la terminologie anglaise "mapping-predistorter". Suivant cette méthode, le signal d'entrée $x_e(t) = I_e(t) + jQ_e(t)$ représentant la sortie désirée de l'amplificateur de puissance, est quantifié sur plusieurs bits pour la partie réelle et la partie imaginaire. Deux tables de correspondance sont constituées, chacune d'elles étant bidimensionnelle, les composantes cartésiennes du signal d'entrée, $I_e(n)$ et $Q_e(n)$ servant de valeurs d'index pour les deux tables. Les tables contiennent des valeurs d'ajustement $f_I(I_e,Q_e)$ et $f_Q(I_e,Q_e)$ qui sont ensuite additionnées aux composantes du signal d'entrée. Cette première méthode de mise en oeuvre procure de très bons résultats, dans la mesure où les effets mémoire de l'amplificateur de puissance sont négligeables. Cependant, les exigences en termes de stockage et/ou de traitement numérique pour l'initialisation et l'adaptation des tables, sont très fortes. Le grand nombre d'entrées induit une convergence très lente dans le cas où une adaptation continue est envisagée, c'est-à-dire lorsque les paramètres du précompensateur sont ajustés de façon continue, pour chaque nouvel échantillon.

Une deuxième méthode connue de mise en oeuvre est la méthode dite du précompensateur polaire, communément désignée selon la terminologie anglaise "Polar distorter". Cette méthode consiste principalement à constituer deux tables de correspondance unidimensionnelles, permettant d'ajuster séparément l'amplitude et la phase du signal d'entrée. Il est en effet possible de recourir à des tables unidimensionnelles puisque la distorsion dans l'amplificateur de puissance est essentiellement causée par la variation de l'amplitude du signal d'entrée. Les tables de correspondance peuvent ainsi être indexées par l'amplitude du signal d'entrée. Par exemple, une première table peut être indexée par l'amplitude du signal d'entrée qui contient les valeurs réelles d'ajustement de l'amplitude seulement. La sortie de cette table peut ensuite être multipliée par l'amplitude du signal d'entrée, et sert à indexer une seconde table contenant les valeurs d'ajustement de la phase. Les tailles des tables utilisées selon cette deuxième méthode sont ainsi sensiblement plus petites que dans le cas de la première méthode décrite précédemment. Cependant, un inconvénient de cette deuxième méthode réside dans le fait qu'une conversion rectangulaire-polaire est nécessaire, cette conversion prenant une majeure partie du temps total de traitement.

Une troisième méthode connue de mise en oeuvre est la méthode dite du précompensateur à gain constant, communément désignée selon la terminologie anglaise "constant-gain predistorter". Cette méthode est largement utilisée, et permet une réduction considérable de la taille des tables et du temps de traitement. Cette troisième méthode ne requiert l'utilisation que d'une seule table unidimensionnelle indexée par l'amplitude du signal d'entrée, et consiste à forcer le précompensateur et l'amplificateur de puissance à maintenir un gain constant pour tous les niveaux de puissance. Cela est rendu possible par le stockage de coefficients de gain complexe en forme cartésienne (I/Q), servant à ajuster les composante I et Q du signal d'entrée simultanément. Les temps de convergence, ainsi que la taille des tables de correspondance en mémoire, peuvent ainsi être réduits considérablement. Avantageusement, des fonctions d'indexage peuvent être développées afin de permettre une meilleure distribution des entrées de la table de correspondance, dans le but de prendre en compte les caractéristiques de l'amplificateur de puissance et les statistiques des signaux déployés.

Une seconde technique connue de prédistorsion numérique adaptative en bande de base, consiste à la mise en oeuvre de modèles mathématiques. D'une manière générale, dans des applications de prédistorsion numérique en bande de base, sur la base de l'hypothèse simplificatrice de mémoire finie à durée de mémoire Q, la relation entre l'enveloppe complexe discrétisée du signal de sortie $\tilde{y}(n)$ de l'amplificateur de puissance par rapport à l'enveloppe complexe du signal d'entrée $\tilde{x}(n)$ peut se formuler via une fonction non-linéaire multidimensionnelle $F_{NL}$, suivant la relation suivante :

$$\tilde{y}(n) = F_{NL}\left(\tilde{x}(n-Q), \tilde{x}^*(n-Q), ..., \tilde{x}(n-1), \tilde{x}^*(n-1), \tilde{x}(n), \tilde{x}^*(n)\right) \qquad (1).$$

Ainsi, il est à noter que dans l'hypothèse où l'effet mémoire de l'amplificateur de puissance est négligeable, le signal de sortie de ce dernier peut être formulé en fonction du signal d'entrée par un modèle polynomial.

La mise en oeuvre de modèles mathématiques peut être délicate, car un modèle mathématique donné ne peut être déterminé que sur la base d'un nombre limité de modes de fonctionnement de l'amplificateur de puissance, notamment dans des conditions environnementales données dont des variations en pratique, peuvent rendre inefficace le modèle mathématique. En outre, la détermination du modèle mathématique est en elle-même difficile, et les algorithmes peuvent être difficiles à mettre en oeuvre.

Deux formes particulières de la fonction $F_{NL}$ sont connues de l'état de la technique, pour la modélisation du comportement des amplificateurs de puissance et/ou de leurs pré-inverses : les séries de Volterra ou les filtres polynomiaux, et les réseaux de neurones.

Quel que soit le modèle adopté pour l'amplificateur de puissance, toute la difficulté réside dans la détermination de son pré-inverse, toujours plus délicate que la modélisation directe de l'amplificateur de puissance. Il existe deux méthodes d'identification connues de l'état de la technique : l'identification directe par l'inversion d'un modèle prédéfini de l'amplificateur de puissance, et l'identification indirecte, consistant à déterminer le post-inverse de l'amplificateur de puissance, pour déterminer la configuration à appliquer au pré-inverse.

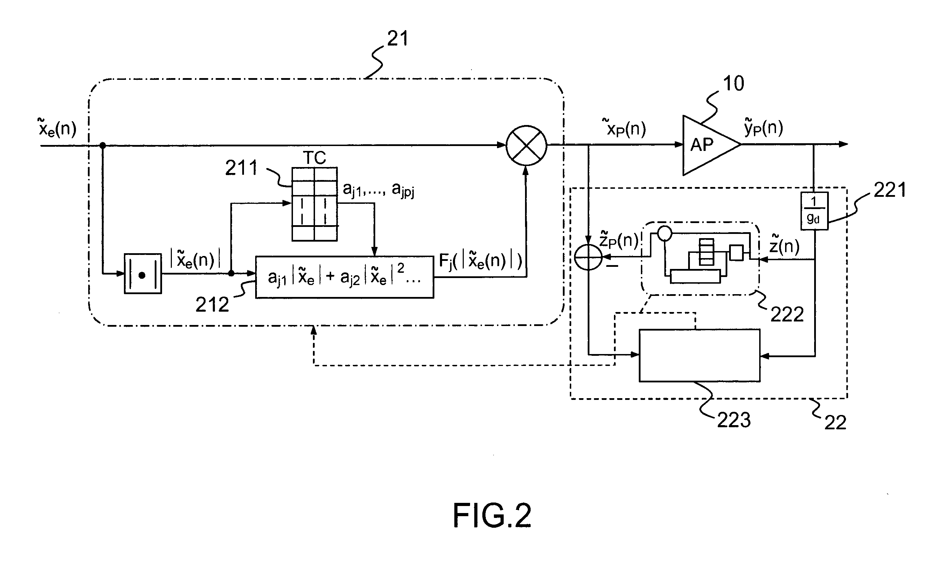

La figure 2 présente le schéma de principe du bloc d'amplification d'une chaîne d'émission comprenant un amplificateur de puissance associé à un dispositif de linéarisation selon un mode de réalisation de la présente invention.

Un bloc d'amplification d'une chaîne d'émission comprend l'amplificateur de puissance 10, un bloc pré-inverse 21 recevant en entrée un signal numérisé représenté par son enveloppe complexe $\tilde{x}_e(n)$ et restituant en sortie un signal $\tilde{x}_p(n)$ attaquant l'entrée de l'amplificateur de puissance 10 ce dernier restituant le signal amplifié représenté par son enveloppe complexe $\tilde{y}(n)$. Dans l'exemple illustré par la figure 2, dans lequel une technique d'identification du précompensateur basée sur une architecture indirecte est utilisée, un bloc d'identification 22 est disposé en parallèle de l'amplificateur de puissance 10.

Le bloc pré-inverse 21 comprend un module table de correspondance TC 211 et un module de modèle paramétrique 212, les deux modules 211, 212 recevant en entrée le module du signal complexe d'entrée $|\tilde{x}_e(n)|$. Le module de modèle paramétrique 212 restitue un signal $F_j(|\tilde{x}_e(n)|)$ en fonction du module du signal complexe d'entrée $|\tilde{x}_e(n)|$ et de paramètres de configuration $\alpha_{j1}, ..., \alpha_{jPj}$ restitués par le module TC 211. Le signal de sortie $\tilde{x}_p(n)$ du bloc pré-inverse 21 est la multiplication du signal complexe d'entrée $\tilde{x}_e(n)$ par le signal de sortie $F_j(|\tilde{x}_e(n)|)$ du module de modèle paramétrique 212.

Le bloc d'identification 22 comprend un atténuateur 221 dont le gain $1/g_d$ est l'inverse du gain désiré $g_d$ de l'amplificateur de puissance 10, un bloc post-inverse 222 recevant en entrée le signal normalisé $\tilde{z}(n)$ issu de l'atténuation du signal $\tilde{y}(n)$ de sortie de l'amplificateur de puissance 10 par l'atténuateur 221. Le bloc post-inverse restitue en sa sortie un signal $\tilde{z}_p(n)$. Le bloc d'identification 22 comprend en outre un bloc d'estimation des paramètres 223. Le bloc d'estimation 223 détermine les paramètres d'identification du bloc pré-inverse 21, par exemple sur la base de la différence entre les signaux $\tilde{z}_p(n)$ et $\tilde{x}_p(n)$, et du signal atténué $\tilde{z}(n)$, ainsi que cela est décrit ci-après.

Dans l'exemple illustré par la figure, où une technique d'identification du bloc pré-inverse 21 basée sur une architecture indirecte est utilisée, la sortie de l'amplificateur de puissance 10 normalisée par le gain désiré $g_d$ de l'amplificateur linéarisé, $\tilde{z}(n) = \tilde{y}(n) / g_d$, est appliquée en entrée du bloc post-inverse 222. Le bloc post-inverse 222 peut par exemple être modélisé par un modèle dit "polynomial quasi-amnésique", en lui-même connu de l'état de la technique. Le modèle polynomial quasi-amnésique est l'équivalent en bande de base du modèle polynomial exprimant le signal de sortie radiofréquence d'un système non linéaire en fonction du signal d'entrée radiofréquence. Le modèle polynomial quasi-amnésique exprime l'enveloppe complexe du signal de sortie en fonction de celle du signal d'entrée. En considérant par exemple les termes d'ordre pair et impair, l'enveloppe complexe du signal en sortie du bloc pré-inverse 21, $\tilde{x}_p(n)$, peut se formuler suivant la relation suivante :

$$\tilde{x}_p(n) = F\left(\left|\tilde{x}_e(n)\right|\right)\tilde{x}_e(n) \qquad (2),$$

où $F\left(\left|\tilde{x}_e(n)\right|\right) = \sum_{k=1}^{K} a_k \left|\tilde{x}_e(n)\right|^{k-1}$ est la fonction de gain du $k=1$ précompensateur, $a_1, \dots a_K$ étant les paramètres du modèle et K son ordre. Il est à noter que les paramètres $a_1, \dots a_K$ peuvent prendre des valeurs complexes, permettant de corriger simultanément les distorsions d'amplitude et de phase. La technique d'identification basée sur une architecture indirecte consiste à identifier, dans un premier temps, le post-inverse de l'amplificateur de puissance 10 ayant le même modèle que celui du bloc pré-inverse 21. Les paramètres, une fois déterminés, sont copiés dans le bloc pré-inverse 21. Suivant la relation (2) ci-dessus, la sortie $\tilde{z}_p(n)$ du bloc post-inverse 222 peut s'écrire suivant la relation suivante :

$$\tilde{z}_p(n) = \sum_{k=1}^{K} a_k \left|\tilde{z}(n)\right|^{k-1} \tilde{z}(n) \qquad (3).$$

Si la sortie de l'amplificateur linéarisé est égale à $g_d\tilde{x}_e(n)$, l'entrée du bloc post-inverse 222 devient $\tilde{z}(n) = \tilde{x}_e(n)$. Dans ce cas, les deux blocs pré-inverse 21 et post-inverse 222 sont respectivement les pré-inverse et post-inverse exacts de l'amplificateur de puissance 10. Ainsi, la sortie $\tilde{z}_p(n)$ du bloc post-inverse 222 devient égale à l'entrée $\tilde{x}_p(n)$ de l'amplificateur de puissance 10. En se basant sur un ensemble d'échantillons d'entrée, $\{\tilde{x}_p(i)\}^n_{i=1}$, et de sortie $\{\tilde{y}_p(i)\}^n_{i=1}$ de l'amplificateur de puissance 10, il est possible d'écrire la relation (3) ci-dessus :

$$z_p = Z\hat{a} \qquad (4),$$

$$\text{où } z_p = \left[\tilde{z}_p(1), \tilde{z}_p(2), \dots, \tilde{z}_p(N)\right]^T = \left[\tilde{x}_p(1), \tilde{x}_p(2), \dots, \tilde{x}_p(N)\right]^T, \text{ et}$$

$$Z = \left[z, |z|z, \dots, |z|^{K-1}z\right],$$

$$\text{avec } z = \left[\tilde{z}(1), \tilde{z}(2), \dots, \tilde{z}(N)\right]^T = \left[\frac{\tilde{y}(1)}{g_d}, \frac{\tilde{y}(2)}{g_d}, \dots, \frac{\tilde{y}(N)}{g_d}\right]^T.$$

Les paramètres du bloc post-inverse 222, qui sont identiques aux paramètres du bloc pré-inverse 21, peuvent alors être estimés en minimisant l'erreur quadratique $\|e(n)\|^2$ où $e(n) = \tilde{x}_p(n) - \tilde{z}_p(n)$. Ainsi, le vecteur des paramètres $\hat{\alpha} = [\alpha_1, \alpha_2, \dots, \alpha_N]^T$ peut être estimé par la technique des moindres carrés :

$$\hat{a} = \left(Z^H Z\right)^{-1} Z^H x_p \qquad (5),$$

où $(.)^H$ est l'opérateur de transposition conjuguée. Une fois que ces paramètres sont déterminés, ils peuvent être injectés dans le bloc pré-inverse 21, le système pouvant alors fonctionner en boucle ouverte. Il est avantageusement possible que la procédure d'identification soit réitérée plusieurs fois, le signal d'entrée $\tilde{x}_e(n)$ étant en première fois utilisé à la place de $\tilde{x}_p(n)$.

Dans la présente invention, l'approche d'implémentation, désignée pour la suite TC / Paramétrique ou TCP, est basée sur l'utilisation d'une table de correspondance mise en oeuvre par le module table de correspondance TC 211, et des modèles paramétriques mis en oeuvre par le module de modèle paramétrique 212. Selon un mode de réalisation, il est possible de découper le domaine d'amplitude du signal d'entrée en un nombre $N_{TCP}$ de segments. Dans chacun de ces segments, un modèle paramétrique peut être identifié pour modéliser localement les caractéristiques pré-inverses de l'amplificateur de puissance 10.

La segmentation peut être uniforme, les segments étant alors de même taille et répartis uniformément sur le domaine d'amplitude d'entrée. Avantageusement, la segmentation peut être basée sur un changement de courbure détectable des caractéristiques : visuellement à partir des caractéristiques AM/AM et AM/PM de l'amplificateur de puissance 10 ou bien mathématiquement à l'aide des dérivées première ou seconde des caractéristiques. Dans le cas d'une segmentation uniforme, en supposant que l'amplitude du signal d'entrée varie entre une amplitude minimale Amin et

une amplitude maximale $A_{max}$, la longueur $L_{seg}$ de chaque segment est égale à $\dfrac{A_{max} - A_{min}}{N_{TCP}}$. Dans l'hypothèse où l'amplitude du signal d'entrée varie entre 0 et une amplitude maximale $A_{max}$, la longueur $L_{seg}$ de chaque segment est égale à $A_{max}/N_{TCP}$. Ainsi, pour le j-ième segment, un modèle paramétrique est identifié pour traiter les échantillons ayant des amplitudes appartenant à l'intervalle [(j-1)$L_{seg}$, j$L_{seg}$]. Cette technique repose sur l'hypothèse que les caractéristiques pré-inverses AM/AM et AM/PM de l'amplificateur de puissance 10 ont une forme polynomiale monotone dans chaque segment, typiquement d'ordre faible, ainsi que cela est habituellement le cas en pratique. Les modèles utilisés peuvent être des modèles polynomiaux d'ordre faible ou des modèles de nature similaire, par exemple des rapports de polynômes, des fonctions hyperboliques, etc.

La fonction de correspondance $F_j(.)$ dans le j-ième segment peut être exprimée par la relation suivante :

$$F_j\left(\left|\tilde{x}_e(n)\right|\right) = a_{j0} + a_{j1}\left|\tilde{x}_e(n)\right| + ... + a_{jP_j}\left|\tilde{x}_e(n)\right|^{P_j} \qquad (6),$$

Ou encore : $\quad F_j\left(\left|\tilde{x}_e(n)\right|\right) = \displaystyle\sum_{p=0}^{P_j} a_{jp}\left|\tilde{x}_e(n)\right|^{p} \qquad (7) ;$

où $P_j$ est l'ordre du polynôme dans le j-ième segment et $a_{jp}$ ses coefficients, p étant un paramètre variant de 0 à $P_j$ (en pratique, $P_j$ est par exemple choisi inférieur ou égal à 3).

Le domaine d'amplitude du signal de sortie normalisé $\tilde{z}(n) = \tilde{y}(n) / g_d$ de l'amplificateur de puissance est d'abord découpé en $N_{TCP}$ segments. Les paramètres $a_{jp}$, correspondant au j-ième segment, sont ensuite estimés à partir des échantillons du signal $\tilde{z}(n)$ qui appartiennent à ce dernier, et les valeurs correspondantes de la fonction de gain du post-inverse de l'amplificateur de puissance 10.

Ces dernières sont déterminées pour chaque paire d'échantillons entrée/sortie du bloc post-inverse 222. La fonction $F_j(.)$ modélisant la fonction de gain du post-inverse de l'amplificateur de puissance 10, dans le j-ième segment, peut s'écrire, de façon similaire, suivant la relation suivante :

$$F_j\left(\left|\tilde{z}(n)\right|\right) = \sum_{p=0}^{P_j} a_{jp}\left|\tilde{z}(n)\right|^{p} = \frac{\tilde{z}_p(n)}{\tilde{z}(n)} \qquad (8) ;$$

où $(\tilde{z}(n),\tilde{z}_p(n))$ est une paire d'échantillons correspondant au j-ième segment. La fonction $F_j(.)$ étant à valeurs complexes, il en est de même pour les paramètres $a_{jp}$ identifiés. Ceci permet une correction simultanée d'amplitude et de phase.

Pour un nombre $N_j$ d'échantillons dans le j-ième segment, il est possible de noter le vecteur d'échantillons en entrée du bloc post-inverse *par $z_j=[\tilde{y}(1)/g_d,...,\tilde{y}(N_j)/g_d]^T$, et* celui des valeurs correspondantes de la fonction $F_j(.)$ par $f_j = [F_j(|\tilde{z}(1)|),...,F_j(|\tilde{z}(N_j)|)]^T$.

Il est alors possible de formuler la solution des moindres carrées qui minimise l'erreur quadratique moyenne dans chaque segment suivant la relation suivante :

$$\hat{a}_j = \left(A_j^H A_j\right)^{-1} A_j^H f_j ;$$

où $\hat{a}_j = \left[a_{j0},...,a_{jP_j}\right]^T$ et $A_j = \left[1,\left|z_j\right|,...,\left|z_j\right|^{P_j}\right]$. Il est à noter que $\tilde{z}_p(n)$ est remplacé par $\tilde{x}_p(n)$ dans la procédure d'identification, et donc par $\tilde{x}_e(n)$ pour la première itération.

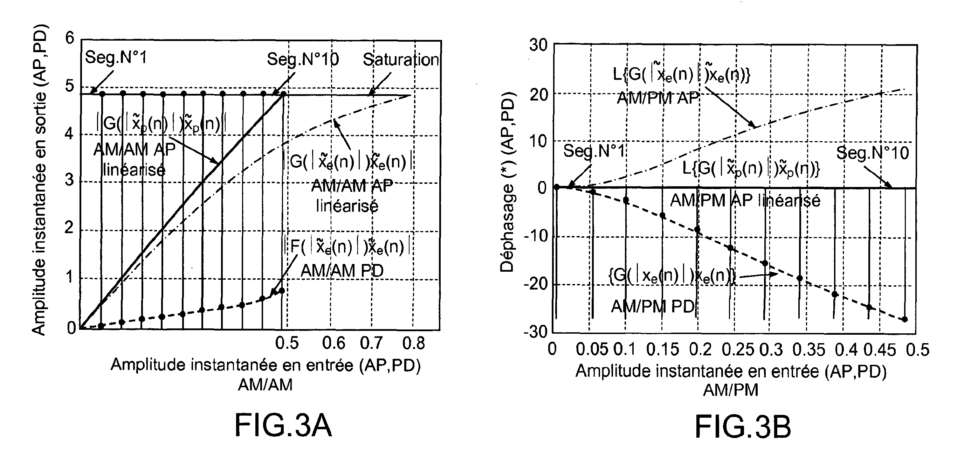

Les figures 3a et 3b présentent les caractéristiques AM/AM, AM/PM, respectivement, de l'amplificateur de puissance, du précompensateur et du système global.

Les courbes présentées dans les figures 3a et 3b sont des représentations respectivement de l'amplitude instantanée de sortie en fonction de l'amplitude instantanée en entrée AM/AM, et du déphasage entre les signaux d'entrée et de sortie en fonction de l'amplitude instantanée en entrée AM/PM, pour un amplificateur de puissance modélisé par un modèle quasi-amnésique de Saleh - dont les coefficients caractéristiques sont choisis de la manière suivante : $\alpha_a = 10, \beta_a = 1, \alpha_\phi = 5, \beta_\phi = 9$ - du précompensateur correspondant et de l'amplificateur linéarisé, pour un nombre de segments $N_{TCP} = 10$ et des polynômes d'ordre 2, soit : $P_j = 2$ et $j = 1, 2, \ldots, 10$. Le modèle de Saleh est communément utilisé pour modéliser les amplificateurs à faible effet mémoire. Il est rappelé ici que si un modèle quasi-amnésique de Saleh est choisi comme équivalent en bande de base de l'amplificateur de puissance 10, alors le signal $\tilde{y}(n)$ de sortie de l'amplificateur de puissance peut être exprimé en fonction du signal d'entrée $\tilde{x}_e(n)$ suivant la relation suivante :

$$\tilde{y}(n) = G\big(|\tilde{x}_e(n)|\big)\tilde{x}_e(n) \qquad\qquad (9) \; ;$$

où $G\big(|\tilde{x}_e(n)|\big) = \dfrac{\alpha_a}{1 + \beta_a |\tilde{x}_e(n)|^2} \exp\left( j\, \dfrac{\alpha_\phi |\tilde{x}_e(n)|^2}{1 + \beta_\phi |\tilde{x}_e(n)|^2} \right)$ est le gain complexe de l'amplificateur de puissance 10, et les paramètres $\alpha_a$, $\beta_a$, $\alpha_\phi$, $\beta_\phi$ peuvent être ajustés de manière adéquate pour approximer les caractéristiques réelles de l'amplificateur de puissance 10. En ce qui concerne la représentation graphique présentée par la figure 3a, celle-ci comprend une première courbe représentée en traits mixtes fins qui représente, en fonction de l'amplitude instantanée du signal d'entrée $|\tilde{x}_e(n)|$, la variation de l'amplitude instantanée du signal de sortie de l'amplificateur de puissance 10 non linéarisé, soit $\left| G\big(|\tilde{x}_e(n)|\big)\tilde{x}_e(n) \right|$, une deuxième courbe représentée en traits pointillés représentant la variation de l'amplitude instantanée du signal prédistordu en sortie du bloc pré-inverse 21, soit $\left| F\big(|\tilde{x}_e(n)|\big)\tilde{x}_e(n) \right|$ et une troisième courbe représentée en traits pleins, représentant la variation de l'amplitude instantanée de l'amplificateur de puissance 10 linéarisé, soit $\left| G\big(|\tilde{x}_p(n)|\big)\tilde{x}_p(n) \right|$. Dans cet exemple, le domaine d'amplitude du signal d'entrée s'étant de 0 à 0,5 V, ainsi les dix segments ont une longueur de 0,05 V. Pour des amplitudes au-delà de 0,5 V, l'amplificateur de puissance fonctionne dans une zone de saturation ne pouvant être exploitée.

En ce qui concerne la représentation graphique présentée par la figure 3b, celle-ci comprend une première courbe représentée en traits mixtes fins qui représente, en fonction de l'amplitude instantanée du signal d'entrée $|\tilde{x}_e(n)|$, la variation du déphasage instantané du signal de sortie de l'amplificateur de puissance 10 non linéarisé, soit $\left| G\big(|\tilde{x}_e(n)|\big)\tilde{x}_e(n) \right|$, une deuxième courbe représentée en traits pointillés représentant la variation du déphasage instantané du signal prédistordu en sortie du bloc pré-inverse 21, soit $\left| F\big(|\tilde{x}_e(n)|\big)\tilde{x}_e(n) \right|$ et une troisième courbe représentée en traits pleins, représentant la variation du déphasage instantané de l'amplificateur de puissance 10 linéarisé, soit $\left| G\big(|\tilde{x}_p(n)|\big)\tilde{x}_p(n) \right|$.

Il est à noter que l'ordre des polynômes peut varier d'un segment à l'autre, et ceci peut avantageusement être mis à profit en pratique de façon à optimiser l'ensemble.

## Revendications

**1.** Dispositif de linéarisation pour amplificateur de puissance (10) par prédistorsion numérique adaptative en bande de base comprenant un bloc pré-inverse (21) recevant un signal d'entrée discrétisé complexe $\tilde{x}_e(n)$ et restituant en entrée de l'amplificateur de puissance (10) un signal prédistordu complexe $\tilde{x}_p(n)$, **caractérisé en ce que** le bloc pré-inverse comprend un premier module (211) et un second module (212) recevant en entrée le module du signal d'entrée complexe $|\tilde{x}_e(n)|$ dont la valeur est comprise dans un domaine d'amplitudes variant entre deux minimale et maximale $A_{min}$ et $A_{max}$, le domaine d'amplitude étant découpé en une pluralité de segments, le premier module (211) comprenant une table de correspondance associant à chaque valeur du module du signal d'entrée complexe

$|\tilde{x}_e(n)|$ contenue dans un segment donné, un jeu prédéfini d'une pluralité de paramètres définissant un modèle paramétrique mis en oeuvre dans le second module (212) via une fonction $F_j$, le second module restituant une valeur $F_j(|\tilde{x}_e(n)|)$, le signal prédistordu complexe résultant de la multiplication du signal d'entrée complexe $\tilde{x}_e(n)$ par la valeur $F_j(|\tilde{x}_e(n)|)$, l'identification du bloc pré-inverse (21) étant basée sur une architecture indirecte formée par un bloc d'identification (22) disposé en parallèle de l'amplificateur de puissance (10), le bloc d'identification (22) identifiant les jeux de paramètres pour chaque segment du domaine d'amplitude du module du signal d'entrée complexe $|\tilde{x}_e(n)|$ en minimisant l'erreur entre le signal d'entrée $\tilde{x}_p(n)$ et le signal de sortie $\tilde{y}(n)$ de l'amplificateur de puissance (10) en au moins une itération.

2. Dispositif de linéarisation pour amplificateur de puissance (10) selon la revendication 1, **caractérisé en ce que** chacun desdits jeux de paramètres prédéfinis pour un segment k donné définit les coefficients complexes d'un polynôme d'ordre $P_k$.

3. Dispositif de linéarisation pour amplificateur de puissance (10) selon la revendication 2, **caractérisé en ce que**, l'amplitude minimale $A_{min}$ étant nulle, le domaine d'amplitude est découpé en un nombre $N_{TCP}$ segments de même longueur $L_{seg}$ égale au rapport de l'amplitude maximale du domaine d'amplitude au nombre de segments $A_{max}/N_{TCP}$, les segments du domaine d'amplitude étant alors des intervalles $[(j-1)L_{seg}, jL_{seg}]$, la table de correspondance associant pour chacun des intervalles un jeu de paramètres complexes $a_{j1}, \dots, a_{jP_j}$ correspondant aux coefficients d'ordre $j_1, \dots j_{P_j}$ du polynôme d'ordre $P_j$.

4. Dispositif de linéarisation pour amplificateur de puissance (10) selon l'une quelconque des revendications précédentes, **caractérisé en ce que** le bloc d'identification (22) comprend un atténuateur (221) atténuant le signal de sortie $\tilde{y}(n)$ de l'amplificateur de puissance (10) par un gain $1/g_d$ égal à l'inverse du gain désiré de l'amplificateur de puissance (10), le signal complexe atténué $\tilde{z}(n)$ étant appliqué en entrée d'un bloc post-inverse (222) restituant en sortie un signal $\tilde{z}_p(n)$, un bloc d'estimation (223) déterminant les paramètres d'identification du bloc pré-inverse (21) à partir de la différence entre le signal d'entrée $\tilde{x}_p(n)$ de l'amplificateur de puissance (10) et le signal de sortie $\tilde{z}_p(n)$ du bloc post-inverse (222) par une minimisation de l'erreur quadratique par la technique des moindres carrés.

**Patentansprüche**

1. Linearisierungsvorrichtung für einen Leistungsverstärker (10) mit adaptiver digitaler Basisbandvorverzerrung, der einen Prä-Inversblock (21) umfasst, der ein diskretisiertes komplexes Eingangssignal $\tilde{x}_e(n)$ umfasst und am Eingang des Leistungsverstärkers (10) ein komplexes vorverzerrtes Signal $\tilde{x}_p(n)$ rekonstituiert, **dadurch gekennzeichnet, dass** der Prä-Inversblock ein erstes Modul (211) und ein zweites Modul (212) umfasst, die am Eingang das Modul des komplexen Eingangssignals $|\tilde{x}_e(n)|$ empfangen, dessen Wert zwischen einer Amplitudendomäne liegt, die zwischen zwei Mindest-$A_{min}$ und Höchst-$A_{max}$ Werten variieren, wobei die Amplitudendomäne in mehrere Segmente unterteilt ist, wobei das erste Modul (211) eine Korrespondenztabelle umfasst, die einen vordefinierten Satz von mehreren Parametern, die ein in dem zweiten Modul (212) implementiertes parametrisches Modell über eine Funktion Fj definieren, mit jedem Wert des Moduls des komplexen Eingangssignals $|\tilde{x}_e(n)|$ assoziieren, das in einem gegebenen Segment enthalten ist, wobei das zweite Modul einen Wert $F_j(|\tilde{x}_e(n)|)$ rekonstituiert, wobei das komplexe vorverzerrte Signal von der Multiplikation des komplexen Eingangssignals $\tilde{x}_e(n)$ mit dem Wert $F_j(|\tilde{x}_e(n)|)$ resultiert, wobei die Identifikation des Prä-Inversblocks (21) auf einer indirekten Architektur basiert, die von einem Identifikationsblock (22) gebildet wird, der parallel zu dem Leistungsverstärker (10) angeordnet ist, wobei der Identifikationsblock (22) die Sätze von Parametern für jedes Segment der Amplitudendomäne des Moduls des komplexen Eingangssignals $|\tilde{x}_e(n)|$ durch Minimieren des Fehlers zwischen dem Eingangssignal $\tilde{x}_p(n)$ und dem Ausgangssignal $\tilde{y}(n)$ des Leistungsverstärkers (10) in wenigstens einer Iteration identifiziert.

2. Linearisierungsvorrichtung für einen Leistungsverstärker (10) nach Anspruch 1, **dadurch gekennzeichnet, dass** jeder der Sätze von vordefinierten Parametern für ein gegebenes Segment k die komplexen Koeffizienten eines Polynoms der Ordnung $P_k$ definiert.

3. Linearisierungsvorrichtung für einen Leistungsverstärker (10) nach Anspruch 2, **dadurch gekennzeichnet, dass**, wenn die Mindestamplitude $A_{min}$ null ist, die Amplitudendomäne in eine Anzahl $N_{TCP}$ von Segmenten derselben Länge $L_{seg}$ von gleich dem Verhältnis zwischen der maximalen Amplitude der Amplitudendomäne und der Anzahl von Segmenten $A_{max}/N_{TCP}$ unterteilt wird, wobei die Segmente der Amplitudendomäne dann Intervalle $[(j-1)L_{seg}, jL_{seg}]$ sind, wobei die Korrespondenztabelle für jedes der Intervalle einen Satz von komplexen Parametern $a_{j1}, \dots a_{jP_j}$ assoziiert, die Koeffizienten der Ordnung von $j_1, \dots j_{P_j}$ des Polynoms der Ordnung $P_j$ entsprechen.

**4.** Linearisierungsvorrichtung für einen Leistungsverstärker (10) nach einem der vorherigen Ansprüche, **dadurch gekennzeichnet, dass** der Identifikationsblock (22) einen Dämpfer (221) umfasst, der das Ausgangssignal $\tilde{y}(n)$ des Leistungsverstärkers (10) durch einen Gewinn $1/g_d$ dämpft, der gleich der Umkehr des gewünschten Gewinns des Leistungsverstärkers (10) ist, wobei das gedämpfte komplexe Signal $\tilde{z}(n)$ an den Eingang eines Post-Inversblocks (222) angelegt wird, der ein Signal $\tilde{z}_p(n)$ am Ausgang rekonstituiert, wobei ein Schätzblock (223) die Identifikationsparameter des Prä-Inversblocks (21) auf der Basis der Differenz zwischen dem Eingangssignal $\tilde{x}_p(n)$ des Leistungsverstärkers (10) und dem Ausgangssignal $\tilde{z}_p(n)$ des Post-Inversblocks (222) durch Minimieren des quadratischen Fehlers mit der Kleinste-Quadrate-Technik ermittelt.

**Claims**

**1.** A linearization device for a power amplifier (10) using adaptive baseband digital pre-distortion comprising a pre-inverse block (21) receiving a complex discretised input signal $\tilde{x}_e(n)$ and restoring a complex pre-distorted signal $\tilde{x}_p(n)$ at the input of said power amplifier (10), **characterised in that** said pre-inverse block comprises a first module (211) and a second module (212) receiving at the input the modulus of the complex input signal $|\tilde{x}_e(n)|$, the value of which is between an amplitudes domain varying between two minimum $A_{min}$ and maximum $A_{max}$ values, with the amplitude domain being split into a plurality of segments, said first module (211) comprising a correspondence table associating a predefined set of a plurality of parameters defining a parametric model implemented in said second module (212) via a function Fj with each value of the modulus of said complex input signal $|\tilde{x}_e(n)|$ contained in a given segment, said second module restoring a value $F_j(|\tilde{x}_e(n)|)$, with said complex pre-distorted signal resulting from the multiplication of said complex input signal $\tilde{x}_e(n)$ by the value $F_j(|\tilde{x}_e(n)|)$, with the identification of said pre-inverse block (21) being based on an indirect architecture formed by an identification block (22) disposed parallel to said power amplifier (10), said identification block (22) identifying the sets of parameters for each segment of the amplitude domain of said modulus of said complex input signal $|\tilde{x}_e(n)|$ by minimising the error between said input signal $\tilde{x}_p(n)$ and the output signal $\tilde{y}(n)$ of said power amplifier (10) in at least one iteration.

**2.** The linearization device for a power amplifier (10) according to claim 1, **characterised in that** each of said sets of predefined parameters for a given segment k defines the complex coefficients of a polynomial of order $P_k$.

**3.** The linearization device for a power amplifier (10) according to claim 2, **characterised in that**, with the minimum amplitude $A_{min}$ being zero, the amplitude domain is split into a number $N_{TCP}$ of segments of the same length $L_{seg}$ equal to the ratio of the maximum amplitude of the amplitude domain to the number of segments $A_{max}/N_{TCP}$, with the segments of the amplitude domain then being intervals $[(j-1)L_{seg}, jL_{seg}]$, the correspondence table associating, for each of the intervals, a set of complex parameters $a_{j1},...a_{jP_j}$ corresponding to coefficients of the order of $j_1,...j_{P_j}$ of the polynomial of order $P_j$.

**4.** The linearization device for a power amplifier (10) according to any one of the preceding claims, **characterised in that** said identification block (22) comprises an attenuator (221) attenuating said output signal $\tilde{y}(n)$ of said power amplifier (10) by a gain $1/g_d$ that is equal to the inverse of the desired gain of said power amplifier (10), with the attenuated complex signal $\tilde{z}(n)$ being applied at the input of a post-inverse block (222) restoring a signal $\tilde{z}_p(n)$ at the output, with an estimation block (223) determining the identification parameters of said pre-inverse block (21) on the basis of the difference between said input signal $\tilde{x}_p(n)$ of said power amplifier (10) and said output signal $\tilde{z}_p(n)$ of said post-inverse block (222) by minimising the quadratic error using the least squares technique.

FIG.1

EP 2 341 614 B1

FIG.2

FIG.3A

FIG.3B

**EP 2 341 614 B1**

## RÉFÉRENCES CITÉES DANS LA DESCRIPTION

**Documents brevets cités dans la description**

- WO 2004086607 A